(19) Europäisches Patentamt
European Patent Office
Office européen des brevets

(11) **EP 4 607 223 A1**

(12) **EUROPEAN PATENT APPLICATION**
published in accordance with Art. 153(4) EPC

(43) Date of publication:
**27.08.2025 Bulletin 2025/35**

(21) Application number: 24863038.6

(22) Date of filing: 06.08.2024

(51) International Patent Classification (IPC):
*G01R 31/56* (2020.01)    *G01R 27/02* (2006.01)
*G01R 1/20* (2006.01)     *G01R 15/04* (2006.01)
*G01R 19/165* (2006.01)

(52) Cooperative Patent Classification (CPC):
**G01R 1/20; G01R 15/04; G01R 19/165;**
**G01R 27/02; G01R 31/56;** Y02E 60/10

(86) International application number:
**PCT/KR2024/011565**

(87) International publication number:
**WO 2025/053456 (13.03.2025 Gazette 2025/11)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **05.09.2023 KR 20230117682**

(71) Applicant: **LG Energy Solution, Ltd.**
**Seoul 07335 (KR)**

(72) Inventor: **CHOI, Jang Hyeok**
**Daejeon 34122 (KR)**

(74) Representative: **Plasseraud IP**
**104 Rue de Richelieu**
**CS92104**
**75080 Paris Cedex 02 (FR)**

(54) **INSULATION DIAGNOSIS CIRCUIT AND BATTERY SYSTEM INCLUDING SAME**

(57) Provided is an insulation diagnostic circuit for diagnosing an insulation state of a battery pack, the circuit including: a first resistor and a second resistor connected in series between a positive terminal of the battery pack and a first node; a first switch connected between a second node to which the first resistor and the second resistor are connected and a negative terminal of the battery pack; a third resistor connected between the first node and a third node; and a fourth resistor connected in series between the third node and the negative terminal of the battery pack.

[FIG. 2]

**Description**

**[Technical Field]**

CROSS-REFERENCE TO RELATED APPLICATION

This application claims priority to and the benefit of Korean Patent Application No. 10-2023-0117682 filed in the Korean Intellectual Property Office on September 05, 2023, the entire contents of which are incorporated herein by reference.

The present disclosure relates to an insulation diagnostic circuit and a battery system including the same.

**[Background Art]**

An insulation resistance of a battery may be an important safety item required for the battery. A vehicle equipped with the battery, a light electric vehicle, or the like may command a battery management system (BMS) equipped with the battery to measure and diagnose the insulation resistance in order to ensure safety of the battery. The BMS may use an expensive component such as a photovoltaic metal oxide semiconductor (photoMOS) relay to measure the insulation resistance. There is a need to reduce a cost of equipping the BMS with the component for measuring the insulation resistance of the battery.

**[Disclosure]**

**[Technical Problem]**

The present disclosure attempts to provide an insulation diagnostic circuit that may reduce a cost of implementing a circuit for measuring an insulation resistance of a battery, and a battery system including the same.

**[Technical Solution]**

According to an aspect, provided is an insulation diagnostic circuit for diagnosing an insulation state of a battery pack, the circuit including: a first resistor and a second resistor connected in series between a positive terminal of the battery pack and a first node; a first switch connected between a second node to which the first resistor and the second resistor are connected and a negative terminal of the battery pack; a third resistor connected between the first node and a third node; and a fourth resistor connected in series between the third node and the negative terminal of the battery pack.

The first node may be connected to a ground.

The circuit may further include: a second switch connected between the first node and a ground; and a third switch connected between the third node and one end of the fourth resistor.

When the second switch and the third switch are in on states and the first switch is in an off state, the first resistor and the second resistor may be connected in series between the positive terminal of the battery pack and the ground, the third resistor and the fourth resistor may be connected in series between the negative terminal of the battery pack and the ground, a first insulation resistance may be formed between the ground and the positive terminal of the battery pack, and a second insulation resistance may be formed between the ground and the negative terminal of the battery pack.

When the first switch to the third switch are in the on states, the second resistor may be connected between the ground and the negative terminal of the battery pack, the third resistor and the fourth resistor may be connected between the ground and the negative terminal of the battery pack, a first insulation resistance may be formed between the ground and the positive terminal of the battery pack, and a second insulation resistance may be formed between the ground and the negative terminal of the battery pack.

The second switch may be implemented as a photovoltaic metal oxide semiconductor (photoMOS) relay, and the first switch and the third switch may be implemented as field-effect transistors (FETs).

According to another aspect, provided is a battery system including: a battery pack including a plurality of battery cells; an insulation diagnostic circuit for diagnosing an insulation state of the battery pack; and a cell monitoring integrated circuit (IC) for diagnosing the insulation state of the battery pack by using an insulation sensing voltage provided from the insulation diagnostic circuit. The insulation diagnostic circuit may include a first resistor and a second resistor connected in series between a positive terminal of the battery pack and a first node, a first switch connected between a second node to which the first resistor and the second resistor are connected and a negative terminal of the battery pack, a third resistor connected between the first node and a third node, and a fourth resistor connected in series between the third node and the negative terminal of the battery pack.

The first node may be connected to a ground.

The insulation diagnostic circuit may further include a second switch connected between the first node and a ground, and a third switch connected between the third node and one end of the fourth resistor.

The cell monitoring IC may calculate a positive terminal insulation resistance between the positive terminal of the battery pack and a ground and a negative terminal insulation resistance between the negative terminal of the battery pack and the ground by using a first insulation sensing voltage, which is a voltage of the third node when the first switch is in an off state, and a second insulation sensing voltage, which is a voltage of the third node when the first switch is in an on state.

The first insulation sensing voltage may be a voltage that a ground voltage is resistance-divided by the third resistor and the fourth resistor, and the ground voltage may be a voltage that a voltage of the battery pack is resistance-divided by a first insulation resistance and a second insulation resistance. The first insulation resistance may be an equivalent parallel resistance of the third resistor and the fourth resistor connected in series, and the positive terminal insulation resistance, and the second insulation resistance may be an equivalent parallel resistance of the first resistor and the second resistor connected in series, and the positive terminal insulation resistance.

The second insulation sensing voltage may be a voltage that a ground voltage is resistance-divided by the third resistor and the fourth resistor, and the ground voltage may be a voltage that a voltage of the battery pack is resistance-divided by a first insulation resistance and a second insulation resistance. The first insulation resistance may be an equivalent parallel resistance of the third resistor and the fourth resistor connected in series, the second resistor, and the node when the first switch is in the off state, and the second insulation sensing voltage, which is the voltage of the third node when the first switch is in the on state.

The cell monitoring IC may determine that insulation between the positive terminal of the battery pack and the ground, and insulation between the negative terminal of the battery pack and the ground are all in an abnormal state when the first insulation sensing voltage is a predetermined first reference voltage or less and a predetermined second reference voltage or more, and the second insulation sensing voltage is a predetermined third reference voltage or more.

The cell monitoring IC may determine that insulation between the positive terminal of the battery pack and the ground, and insulation between the negative terminal of the battery pack and the ground are all in a normal state when the first insulation sensing voltage is a predetermined first reference voltage or less and a predetermined second reference voltage or more, and the second insulation sensing voltage is less than a predetermined third reference voltage.

The cell monitoring IC may determine that insulation between the positive terminal of the battery pack and the ground in a normal state, and insulation between the negative terminal of the battery pack and the ground is in an abnormal state when the first insulation sensing voltage is a predetermined first voltage.

The cell monitoring IC may determine that insulation between the negative terminal of the battery pack and the ground in a normal state, and insulation between the positive terminal of the battery pack and the ground is in an abnormal state when the first insulation sensing voltage is more than a predetermined first reference voltage.

The cell monitoring IC may generate a second switching control signal and a third switching control signal that are on levels for turning on the second switch and the third switch in a first period, and a first switching control signal that is the on level for turning on the first switch in a second period, the first period and the second period may overlap each other, and the first period may be longer than the second period.

The cell monitoring IC may generate a second switching control signal and a third switching control signal that are on levels for turning on the second switch and the third switch in a first period and a second period, and generates the second switching control signal that is the on level for turning on the first switch in the second period.

**[Advantageous Effects]**

As set forth above, the present disclosure provides the insulation diagnostic circuit that may reduce the cost of implementing the circuit for measuring the insulation resistance of the battery, and the battery system including the same.

**[Description of the Drawings]**

FIG. 1 is a diagram showing a battery system according to an embodiment.
FIG. 2 is a circuit diagram showing a partial configuration of the battery system according to an embodiment.
FIG. 3 is a circuit diagram showing a plurality of switches in an insulation diagnostic circuit according to an embodiment.
FIG. 4 is a waveform diagram showing signals controlling switching of the plurality of switches according to an embodiment.
FIG. 5 is a circuit diagram showing an equivalent circuit of the insulation diagnostic circuit in a period TP1.
FIG. 6 is a circuit diagram showing the equivalent circuit of the insulation diagnostic circuit in a period TP2.
FIG. 7 is a flowchart showing a method for determining an insulation state according to an embodiment.
FIG. 8 is a waveform diagram showing signals controlling switching of the plurality of switches according to another embodiment.
FIG. 9 is a waveform diagram showing signals controlling switching of the plurality of switches according to still another embodiment.
FIG. 10 is a diagram showing an insulation diagnostic circuit according to still another embodiment.

**[Mode for Invention]**

In describing embodiments disclosed in the specification, omitted is a detailed description of a case where it is decided that the detailed description of the known art related to the present disclosure may obscure the gist of the present disclosure. In addition, it is to be understood that the accompanying drawings are provided only to allow the embodiments disclosed in the specification to be easily understood, and the spirit of the present disclosure disclosed herein is not limited by the accompanying drawings and includes all the modifications, equivalents, and substitutions included in the spirit and scope of the present disclosure.

Terms including ordinal numbers such as "first" or "second" may be used to describe various components. However, these components are not limited to these terms. These terms are used only to distinguish one component and another component from each other.

It is to be understood that if one component is referred to as being "connected to" or "coupled to" another component, one component may be directly connected to or directly coupled to another component, or may be connected to or coupled to another component while having a third component interposed therebetween. On the other hand, it is to be understood that if one component is referred to as being "directly connected to" or "directly coupled to" another component, one component may be connected or coupled to another component without a third component interposed therebetween.

It is to be understood that terms "include", "have", and the like used in the present application specify the presence of features, numerals, steps, operations, components, parts or combinations thereof, mentioned in the specification, and do not preclude the presence or addition of one or more other features, numerals, steps, operations, components, parts or combinations thereof.

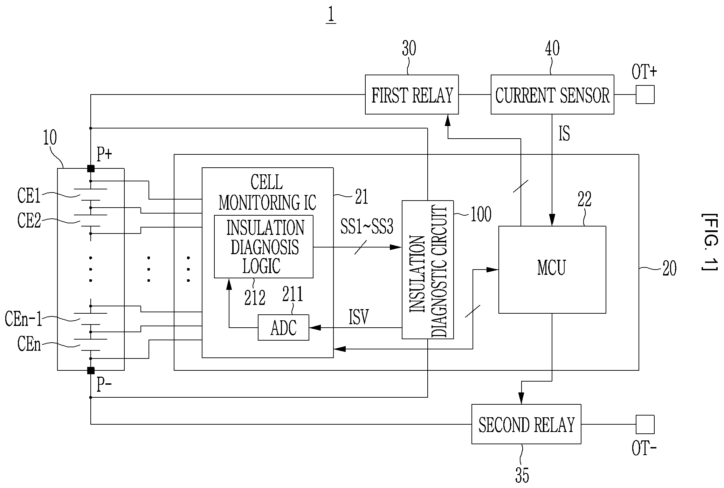

FIG. 1 is a diagram showing a battery system according to an embodiment.

A battery system 1 may include a battery pack 10, a battery management system (BMS) 20, a first relay 30, a second relay 35, a current sensor 40, and an insulation diagnostic circuit 100.

The battery pack 10 may include a plurality of battery cells CE1 to CEn connected in series with each other. When the first relay 30 is closed, a positive terminal P+ of the battery pack 10 may be electrically connected to an external connection terminal OT+ of the battery system 1. When the second relay 35 is closed, a negative terminal P- of the battery pack 10 may be electrically connected to an external connection terminal OT- of the battery system 1.

The current sensor 40 may detect a current (hereinafter, battery current) flowing in the battery pack 10, and the current sensor 40 may transmit a signal IS indicating the detected current to the BMS 20.

The BMS 20 may include a cell monitoring integrated circuit (IC) 21, a main control unit (MCU) 22, and the insulation diagnostic circuit 100. The cell monitoring IC 21 may be connected to the plurality of battery cells CE1 to CEn, and measure a plurality of cell voltages of the plurality of battery cells CE1 to CEn and a voltage (hereinafter, battery voltage) across the battery pack 10. The cell monitoring IC 21 may generate a signal indicating the plurality of measured cell voltages and the battery voltage and provide the same to the MCU 22.

The cell monitoring IC 21 may control the insulation diagnostic circuit 100 to thus collect the measured voltages required to calculate an insulation resistance of the battery pack 10. The cell monitoring IC 21 may control an operation of the insulation diagnostic circuit 100 to collect the measured voltages. The cell monitoring IC 21 may determine an insulation state of the battery pack 10 based on the measured voltages. The cell monitoring IC 21 may calculate the insulation resistance of the battery pack 10 based on the measured voltages, and determine the insulation state of the battery pack 10.

The MCU 22 may collect information on the plurality of battery cell voltages, the battery voltage, the battery current, a temperature of the battery pack 10, or the like, control the charging and discharging current of the battery pack 10 based on the collected plurality of cell voltages, battery current, or the like, and control a cell balancing operation for the plurality of battery cells CE1 to CEn. The MCU 22 may control the opening and closing of the first relay 30 and the second relay 35 for the charging and discharging control of the battery pack 10. The MCU 22 may generate relay control signals that control the opening and closing of the first and second relays 30 and 35, and provide the same to the first and second relays 30 and 35. The MCU 22 may receive the insulation state of the battery pack 10 from the cell monitoring IC 21, and stop an operation of the battery back 10 or transmit the insulation state of the battery pack 10 to an external device through wired or wireless communication if an insulation abnormality occurs between the positive terminal P+ and/or negative terminal P-of the battery pack 10 and a ground.

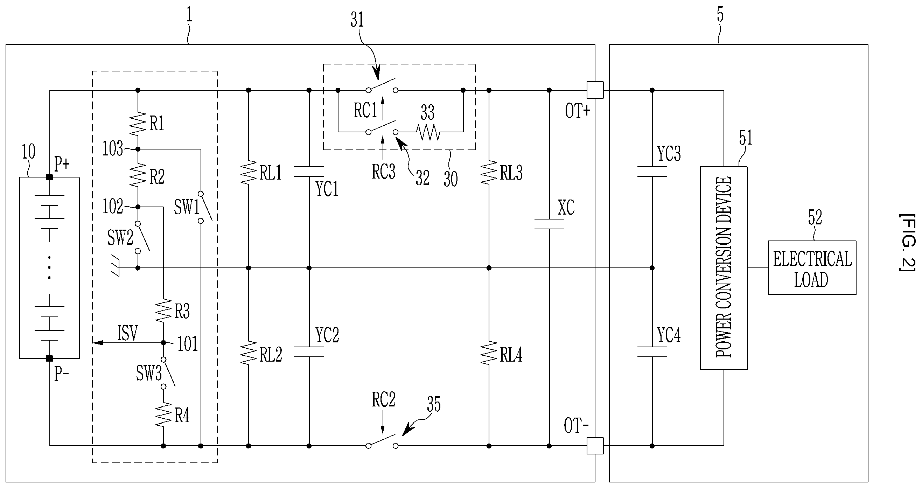

FIG. 2 is a circuit diagram showing a partial configuration of the battery system according to an embodiment.

FIG. 2 specifically shows the battery pack 10, the first relay 30, the second relay 35, and the insulation diagnostic circuit 100. For convenience of explanation, a partial configuration shown in FIG. 1 may be omitted from FIG. 2. In FIG. 2, an external device 5 may be connected between the external connection terminal OT+ and external connection terminal OT- of the battery system 1. This configuration is one application example to explain the battery system 1, and does not limit the present disclosure. The external device 5 shown in FIG. 2 may be a vehicle. The external device 5 may include two Y capacitors YC3 and YC4 connected in series between the external connection terminal OT+ and the external connection terminal OT-, a power conversion device 51, and an electrical load 52. The power conversion device 51 may be an inverter, and the electrical load 52 may be a motor. An X capacitor XC may be connected between the external connection terminal OT+ and the external connection terminal OT-.

The first relay 30 may include a main relay 31, a precharge relay 32, and a precharge resistor 33. The main relay 31 may be connected between the positive terminal P+ and the external connection terminal OT+, and the precharge relay 32 and the precharge resistor 33 may be connected in series between the positive terminal P+ and the external connection terminal OT+. The precharge relay 32 and the precharge resistor 33, which are connected in series with each other, and the main relay 31 may be connected in parallel between the positive terminal P+ and the external connection terminal OT+. The main relay 31 may be closed based on a relay control signal RC1 of an on level, and opened based on the relay control signal RC1 of an off level. The precharge relay 32 may be closed based on a relay control signal RC3 of the on level and opened based on the relay control signal RC3 of the off level. The second relay 35 may be connected between the negative terminal P- and the external connection terminal OT-, and may be closed based on a relay control signal RC2 of the on level, and based on the relay control signal RC2 of the off level. The main relay 31 may be closed after the second relay 35 and the precharge relay 32 are closed, and the precharge relay 32 may be opened after the main relay 31 is closed.

A Y capacitor YC1 may be connected between the positive terminal P+ and the ground, and a Y capacitor YC2 may be connected between the negative terminal P- and the ground. An insulation resistance RL1 may indicate insulation between the positive terminal P+ of the battery pack 10 and the ground, and an insulation resistance RL2 may indicate insulation between the negative terminal P- of the battery pack 10 and the ground. An insulation resistance RL3 may indicate insulation between a wiring between the positive terminal P+ of the battery pack 10 and the external connection terminal OT+ and the ground, and an insulation resistance RL4 may indicate insulation between a wiring between the negative terminal P- of the battery pack 10 and the external connection terminal OT- and the ground.

When an insulation diagnosis is performed and the first relay 30 is in the closed state, an equivalent parallel resistance of the insulation resistance RL1 and the insulation resistance RL3 may indicate the insulation between the positive terminal of the battery pack 10 and the ground. When the insulation diagnosis is performed and the second relay 35 is in the closed state, an equivalent parallel resistance of the insulation resistance RL2 and the insulation resistance RL4 may indicate the insulation between the negative terminal of the battery pack 10 and the ground. On the other hand, when the insulation diagnosis is performed and the first relay 30 is in the opened state, the insulation resistance RL1 may indicate the insulation between the positive terminal of the battery pack 10 and the ground. When the insulation diagnosis is performed and the second relay 35 is in the opened state, the insulation resistance RL2 may indicate the insulation between the negative terminal of the battery pack 10 and the ground.

Hereinafter, a resistance indicating the insulation between the positive terminal of the battery pack 10 and the ground is referred to as a positive terminal insulation resistance, and a resistance indicating the insulation between the negative terminal of the battery pack 10 and the ground is referred to as a negative terminal insulation resistance.

The insulation between the positive terminal P+ and the ground may be considered to be broken when the positive terminal insulation resistance is less than a predetermined critical value, and the insulation between the negative terminal P- and the ground may be considered to be broken when the negative terminal insulation resistance is less than the predetermined critical value. The battery pack 10 is required to be electrically insulated from the external device 5. If the battery pack 10 is not insulated from the ground, the external device 5 and the battery pack 10 may be connected to each other via the ground to thus break the insulation between the battery pack 10 and the external device 5. The BMS 20 according to an embodiment may calculate the positive terminal insulation resistance and the negative terminal insulation resistance by using the insulation diagnostic circuit 100, compare the calculated values with the critical value, and determine the insulation state between the battery pack 10 and the ground based on a comparison result. Alternatively, the BMS 20 may determine the insulation state of the positive terminal or negative terminal of the battery pack 10 by using the voltages detected using the insulation diagnostic circuit 100. "The insulation state" may include a normal insulation state where the insulation resistance between two components is the predetermined critical value or more, and an abnormal insulation state where the insulation resistance is less than the critical value.

The insulation diagnostic circuit 100 may be connected to the positive terminal P+ and negative terminal P- of the battery pack 10 and the ground. The insulation diagnostic circuit 100 may include three switches SW2, SW1, and SW3 and four resistors R1 to R4.

The switch SW2, the resistor R1, and the resistor R2 may be connected between the positive terminal P+ of the battery pack 10 and the ground, and the switch SW3, the resistor R3, and the resistor R4 may be connected between the negative terminal of the battery pack 10 and a contact point 102.

One end of the resistor R1 may be connected to the positive terminal P+ of the battery pack 10, and the other end of the resistor R1 and one end of the resistor R2 may be connected to a contact point 103. The other end of the resistor R2 and one end of the switch SW2 may be connected to the contact point 102, and the other end of the switch SW2 may be connected to the ground. One end of the resistor R3 may be connected to the contact point 102, and the other end of the resistor R3 and one end of the switch SW3 may be connected to a contact point 101. The other end of the switch SW3 may be connected to one end of the resistor R4, and the other end of the resistor R4 may be connected to the negative terminal P- of the battery pack 10. The switch SW1 may be connected between the contact point 103 and the negative terminal P-. A voltage (or insulation sensing voltage) ISV at the contact point 101 may be provided to the cell monitoring IC 21. The cell monitoring IC 21 may include an analog-to-digital converter (ADC) 211 and an insulation diagnosis logic 212. The ADC 211 may convert the insulation sensing voltage ISV into a digital value and provide the same to the insulation diagnosis logic 212. The insulation diagnosis logic 212 may use the digital value to thus calculate each value of the positive terminal insulation resistance between the positive terminal P+ of the battery pack 10 and the ground and the negative terminal insulation resistance between the negative terminal P- of the battery pack 10 and the ground. The insulation diagnosis logic 212 may compare each value of the positive terminal insulation resistance and the negative terminal insulation resistance with the critical value, and determine 1) the normal insulation state, 2) a negative terminal insulation state, 3) a positive terminal insulation state, or 4) an insulation abnormality state based on the comparison result.

1) The normal insulation state may indicate that both the positive and negative terminals of the battery pack are in a state of being insulated from the ground. 2) The negative terminal insulation state may indicate that the negative terminal of the battery pack is in a state of being insulated from the ground, and the positive terminal of the battery pack is in a state of abnormality occurring in its insulation from the ground. 3) The positive terminal insulation state may indicate that the positive terminal of the battery pack is in the state of being insulated from the ground, and the negative terminal of the battery pack is in the state of abnormality occurring in its insulation from the ground. 4) The insulation abnormality state may indicate that both the positive and negative terminals of the battery pack are in the state of abnormality occurring in their insulations from the ground. In the normal insulation state, resistance values of both the positive terminal insulation resistance and the negative terminal insulation resistance may be the critical value or more. In the negative terminal insulation state, a negative terminal insulation resistance value may be the critical value or more, and a positive terminal insulation resistance value may be less than or equal to the critical value. In the positive terminal insulation state, the positive terminal insulation resistance value may be the critical value or more, and the negative terminal insulation resistance value may be less than the critical value. In the insulation abnormality state, the resistance values of both the positive terminal insulation resistance and the negative terminal insulation resistance are less than the critical value.

The cell monitoring IC 21 may generate a plurality of switching control signals SS2 and SS3 that control switching operations of the plurality of switches SW2 and SW3. The cell monitoring IC 21 may supply the plurality of switching control signals SS2 and SS3 to the insulation diagnostic circuit 100 for the insulation diagnosis. The plurality of switches SW2 and SW3 may be turned on or off based on the plurality of switching control signals SS2 and SS3. For example, the on level of the plurality of switching control signals SS2 and SS3 may be a high level, and the off level thereof may be a low level.

The switch SW2 may be turned on when the switching control signal SS2 is at the high level, the switch SW2 may be turned off when the switching control signal SS2 is at the low level, the switch SW1 may be turned on when a switching control signal SS1 is at the high level, the switch SW1 may be turned off when the switching control signal SS1 is at the low level, the switch SW3 may be turned on when the switching control signal SS3 is at the high level, and the switch SW3 may be turned off when the switching control signal SS3 is at the low level.

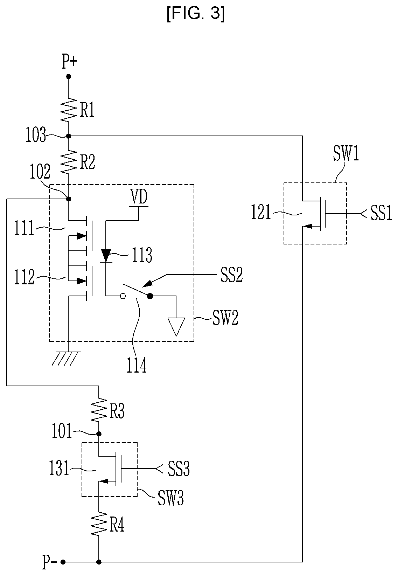

FIG. 3 is a circuit diagram showing the plurality of switches in the insulation diagnostic circuit according to an embodiment.

As shown in FIG. 3, the switch SW2 may be implemented as a photovoltaic metal oxide semiconductor (photoMOS) relay, and the switches SW1 and SW3 may be implemented as field-effect transistor (FETs). The switch SW2 may be operated in a high voltage range, and the switching control signal SS2 may be generated in a low voltage range to thus be implemented as the photoMOS relay. The switches SW1 and SW3 may be connected to the negative terminal P- of the battery pack 10, and perform the switching operations by the switching control signals SS1 and SS3 of a low voltage level.

The switch SW2 may include two MOSFETs 111 and 112 connected in series with each other, a diode 113, and a switching element 114. The switching element 114 may be turned on based on the switching control signal SS2 of the high level which is the on level, and turned off based on the switching signal SS2 of the low level which is the off level. An anode of the diode 113 may be supplied with a power supply voltage VD, a cathode of the diode 113 may be connected to one end of the switching element 114, and the other end of the switching element 114 may be connected to the ground. The ground connected to the other end of the switching element 114 may be a low voltage ground, unlike the ground for the battery pack 10. A drain of the MOSFET 111 may be connected to the contact point 102, a source of the MOSFET 111 may be connected to a source of the MOSFET 112, and a drain of the MOSFET 112 may be connected to the ground. In an on state of the switching element 114, the current may flow through the diode 113, and the MOSFETs 111 and 112 may be turned on based on light emission of the diode 113. In an off state of the switching element 114, no current may flow through the diode 113, and the MOSFETs 111 and 112 may thus be in the off states.

The switch SW1 may be implemented as an n-channel FET, a drain of the switch SW1 may be connected to the contact point 103, a source of the switch SW1 may be connected to the negative terminal P- of the battery pack 10, and the switching control signal SS1 may be supplied to a gate of the switch SW1. The switch SW1 may be turned on by the switching control signal SS1 of the high level which is the on level, and the switch SW1 may be turned off by the switching control signal SS1 of the low level which is the off level.

The switch SW3 may be implemented as the n-channel FET, a drain of the switch SW3 may be connected to the contact point 101, a source of the switch SW3 may be connected to one end of the resistor R4, and the switching control signal SS3 may be supplied to a gate of the switch SW3. The switch SW3 may be turned on by the switching control signal SS3 of the high level which is the on level, and the switch SW3 may be turned off by the switching control signal SS3 of the low level which is the off level.

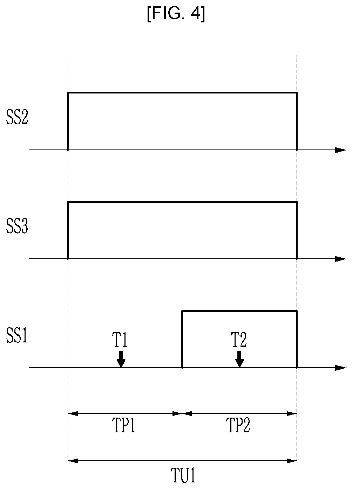

Hereinafter, referring to FIG. 4, the description describes a method of measuring the insulation sensing voltage ISV based on the switching operations of the plurality of switches SW2 and SW3.

FIG. 4 is a waveform diagram showing the signals controlling switching of the plurality of switches according to an embodiment.

A period TU1 in FIG. 4 may be a unit period for the insulation diagnosis. The period TU1 shown in FIG. 4 may be repeated, and the insulation diagnosis may be repeated. When the period TU1 is repeated, a predetermined time interval may exist between two adjacent periods TU1. The MCU 22 may calculate the insulation resistance in each of the repeated insulation diagnoses, and determine the insulation state of the battery pack 10 based on the calculated insulation resistance value.

As shown in FIG. 4, the period TU1 may include a period TP1 and a period TP2. In the period TP1, the switching control signal SS2 and the switching control signal SS3 may be at the high level which is the on level, and the switching control signal SS1 may be at the low level which is the off level.

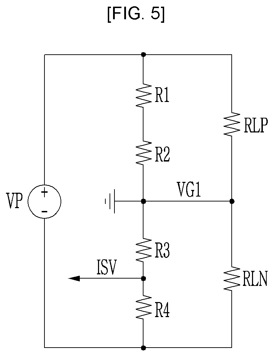

FIG. 5 is a circuit diagram showing an equivalent circuit of the insulation diagnostic circuit in the period TP1.

As shown in FIG. 5, the battery pack 10 may be a voltage source VP. Two resistors R1 and R2 may be connected in series between a positive terminal of the voltage source VP and the ground, and two resistors R3 and R4 may be connected in series between the ground and a negative terminal of the voltage source VP. A positive terminal insulation resistance RLP may be connected between the positive terminal of the voltage source VP and the ground, and a negative terminal insulation resistance RLN may be connected in series between the ground and the negative terminal of the voltage source VP. The positive terminal insulation resistance RLP may be an equivalent parallel resistance RL1∥RL3 of the insulation resistance RL1 and the insulation resistance RL3. The negative terminal insulation resistance RLN may be an equivalent parallel resistance RL2∥RL4 of the insulation resistance RL2 and the insulation resistance RL4. Alternatively, the positive terminal insulation resistance RLP may be the insulation resistance RL1, and the negative terminal insulation resistance RLN may be the insulation resistance RL2.

A time point T1 in FIG. 4 may indicate any time point in the period TP1. The ADC 211 may convert the insulation sensing voltage ISV at the time point T1 into a digital signal. The insulation sensing voltage ISV at the time point T1 may be defined as Equation 1 below.

[Equation 1]

$$ISV = VG1 * R4/ (R3+R4)$$

In Equation 1, "VG1" is the ground voltage at the time point T1, "R3" is the resistance value of the resistor R3, and "R4" is the resistance value of the resistor R4.

A ground voltage VG1 may be defined as Equation 2.

[Equation 2]

$$VG1 = VP * Rn1/ (Rp1+Rn1)$$

In Equation 2, "VP" is a voltage of the voltage source VP, "Rn1" is a negative terminal resistance seen from the ground at the time point T1, and "Rp2" is a positive terminal resistance seen from the ground at the time point T1. The negative terminal resistance Rn1 may be an equivalent parallel resistance ((R3+R4)∥RLP) of two resistors R3 and R4 connected in series and the positive terminal insulation resistance RLP. A positive terminal resistance Rp1 may be an equivalent parallel resistance ((R1+R2)∥RLP) of two resistors R1 and R2 connected in series and the positive terminal insulation resistance RLP.

In the period TP2, the switching control signal SS2, the switching control signal SS1, and the switching control signal SS3 may be at the high level which is the on level.

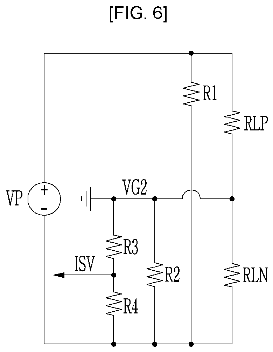

FIG. 6 is a circuit diagram showing the equivalent circuit of the insulation diagnostic circuit in the period TP2.

As shown in FIG. 6, the resistor R1 may be connected between the two terminals of the voltage source VP corresponding to the battery pack 10, and the resistor R1 may be connected between the negative terminal of the voltage source VP and the ground. Two resistors R3 and R4 may be connected in series between the ground and the negative terminal of the voltage source VP. The positive terminal insulation resistance RLP may be connected between the positive terminal of the voltage source VP and the ground, and the negative terminal insulation resistance RLN may be connected in series between the ground and the negative terminal of the voltage source VP.

The time point T2 in FIG. 4 may indicate any time point in the period TP2. The ADC 211 may convert the insulation sensing voltage ISV at the time point T2 into the digital signal. The insulation sensing voltage ISV at the time point T2 may be defined as Equation 3 below.

[Equation 3]

$$ISV = VG2 * R4/ (R3+R4)$$

In Equation 3, "VG2" is the ground voltage at the time point T2, "R3" is the resistance value of the resistor R3, and "R4" is the resistance value of the resistor R4.
A ground voltage VG2 may be defined as Equation 4.

[Equation 4]

$$VG2 = VP * Rn2/ (Rp2+R2n)$$

In Equation 4, "VP" is the voltage of the voltage source VP, "Rn2" is a negative terminal resistance seen from the ground at the time point T2, and "Rp2" is the positive terminal resistance seen from the ground at the time point T2. The negative terminal resistance Rn2 may be an equivalent parallel resistance ((R3+R4)∥R2∥RLN) of two resistors R3 and R4 connected in series, the resistor R2, and the negative terminal insulation resistance RLN. The positive terminal resistance Rp2 is a value of the positive terminal insulation resistance RLP.
The insulation diagnosis logic 212 may be provided with two values of the insulation sensing voltage ISV, which are respectively acquired at the time points T1 and T2, the resistance values of the four resistors R1 to R4, and a voltage value of the battery pack 10, and thus calculate the resistance values of the positive terminal insulation resistance RLP and the negative terminal insulation resistance RLN by using Equations 1 to 4.
The insulation diagnosis logic 212 may compare the resistance values of the positive terminal insulation resistance RLP and the negative terminal insulation resistance RLN with the predetermined critical value, and may determine that the insulation abnormality occurs between the terminal of the battery pack 10, which corresponds to the insulation resistance less than the critical value, and the ground. For example, the insulation diagnosis logic 212 may determine that the battery pack 10 is in the negative terminal insulation state when the resistance value of the positive terminal insulation resistance RLP is less than the critical value, and the resistance value of the negative terminal insulation resistance RLN is the critical value or more. The insulation diagnosis logic 212 may determine that the battery pack 10 is in the positive terminal insulation state when the resistance value of the negative terminal insulation resistance RLN is less than the critical value, and the resistance value of the positive terminal insulation resistance RLP is the critical value or more. The insulation diagnosis logic 212 may determine that the battery pack 10 is in the insulation abnormality state when both the resistance values of the positive terminal insulation resistance RLP and the negative terminal insulation resistance RLN are less than the critical value. The insulation diagnosis logic 212 may determine that the battery pack 10 is in the normal insulation state when both the resistance values of the positive terminal insulation resistance RLP and the negative terminal insulation resistance RLN are the critical value or more.
In the preceding embodiment, the insulation diagnosis is performed by calculating the values of the positive terminal insulation resistance and the negative terminal insulation resistance, and the present disclosure is not limited thereto. The insulation diagnosis logic 212 may determine the insulation state based on the value of the insulation sensing voltage ISV acquired at the time points T1 and T2.
For example, assume that a voltage of the battery pack 10 is 800 V, R1=2.8 MΩ, R2=2.8 MΩ, R3=5.6 MΩ, and R4=30 KΩ, RL1 to RL4 are 10 MΩ in the normal insulation state, and RL1 to RL4 are 100 KΩ in the abnormal insulation state.

1) When the battery pack 10 is in the normal insulation state, the insulation sensing voltage ISV measured at the time point T1 may be 2.13 V, and the insulation sensing voltage ISV measured at the time point T2 may be 0.91 V. In detail, in the normal insulation state, the positive terminal resistance Rp1 at the time point T1 may be (2.8+2.8)∥(10∥10) [MΩ], that is, 2.64 MΩ, and the negative terminal resistance Rn1 may be (5.6+0.03)∥(10∥10)[MΩ], that is, 2.65 MΩ. VG1 at the time point T1 may then be approximately 400 V, and ISV may be 400*(30/5630) or 2.13 V. In the normal insulation state, the negative terminal resistance Rn2 at the time point T2 may be (5.6+0.03)∥2.8∥(10∥10)[MΩ], and when "0.03" is ignored for the convenience of calculation, the value may be 1.36 MΩ, and the positive terminal resistance Rp2 may be (10∥10)[MΩ], that is, 5 MΩ. VG1 at the time point T2 may then be approximately 171 V, and ISV may be 171*(30/5630) or 0.91 V.
2) When the battery pack 10 is in the negative terminal insulation state, the insulation sensing voltage ISV measured at the time point T1 may be 4.2 V, and the insulation sensing voltage ISV measured at the time point T2 may be 4.11 V. In detail, in the negative terminal insulation state, the positive terminal resistance Rp1 at the time point T1 may be (2.8+2.8)∥(0.1∥0.1)[MΩ], that is, approximately 0.05 MΩ, and the negative terminal resistance Rn1 may be (5.6+0.03)∥(10∥10)[MΩ], that is, 2.65 MΩ. VG1 at the time point T1 may then be approximately 785 V, and ISV may be 785*(30/5630) or 4.2 V. In the negative terminal insulation state, the negative terminal resistance Rn2 at the time point T2 may be $(5.6+0.03)\|2.8\|(10\|10)[M\Omega]$, and when "0.03" is ignored for the convenience of calculation, the value may be 1.36 MΩ, and the positive terminal resistance Rp2 may be $(0.1\|0.1)[M\Omega]$, that is, 0.05 MΩ. VG1 at the time point T2 may then be approximately 772 V, and ISV may be 171*(30/5630) or 4.11 V.

3) When the battery pack 10 is in the positive terminal insulation state, the insulation sensing voltage ISV measured at the time point T1 may be 0.08 V, and the insulation sensing voltage ISV measured at the time point T2 may be 0.04 V. In detail, in the positive terminal insulation state, the positive terminal resistance Rp1 at the time point T1 may be $(2.8+2.8)\|(10\|10)[M\Omega]$, that is, 2.64 MΩ, and the negative terminal resistance Rn1 may be $(5.6+0.03)\|(0.1\|0.1)[M\Omega]$, that is, approximately 0.05 MΩ. VG1 at the time point T1 may then be approximately 14.87 V, and ISV may be 14.87*(30/5630) or 0.08 V. In the positive terminal insulation state, the negative terminal resistance Rn2 at the time point T2 may be $(5.6+0.03)\|2.8\|(0.1\|0.1)[M\Omega]$, and when "0.03" is ignored for the convenience of calculation, the value may be 0.049 MΩ, and the positive terminal resistance Rp2 may be $(10\|10)[M\Omega]$, that is, 5 MΩ. VG1 at the time point T2 may then be approximately 7.76 V, and ISV may be 7.76*(30/5630) or 0.04 V.

4) When the battery pack 10 is in the insulation abnormality state, the insulation sensing voltage ISV measured at the time point T1 may be 2.13 V, and the insulation sensing voltage ISV measured at the time point T2 may be 2.13 V. In detail, in the insulation abnormality state, the positive terminal resistance Rp1 at the time point T1 may be $(2.8+2.8)\|(0.1\|0.1)[M\Omega]$, that is, approximately 0.05 MΩ, and the negative terminal resistance Rn1 may be $(5.6+0.03)\|(0.1\|0.1)[M\Omega]$, that is, approximately 0.05 MΩ. VG1 at the time point T1 may then be approximately 400 V, and ISV may be 400*(30/5630) or 2.13 V. In the insulation abnormality state, the negative terminal resistance Rn2 at the time point T2 may be $(5.6+0.03)\|2.8\|(0.1\|0.1)[M\Omega]$, and when "0.03" is ignored for the convenience of calculation, the value may be 0.049 MΩ, and the positive terminal resistance Rp2 may be $(0.1\|0.1)[M\Omega]$, that is, 0.05 MΩ. VG1 at the time point T2 may then be approximately 400 V, and ISV may be 400*(30/5630) or 2.13 V.

In this way, levels of the insulation sensing voltage ISV detected at the time points T1 and T2 may respectively be different from one another in the normal insulation state, the negative terminal insulation state, the positive terminal insulation state, and the insulation abnormality state. That is, instead of calculating the positive terminal insulation resistance and the negative terminal insulation resistance, the insulation diagnosis logic 212 may compare the digital value of the insulation sensing voltage ISV provided from the ADC 211 with a predetermined reference value to thus determine the insulation state between the positive terminal and/or the negative terminal and the ground. The value of the resistor R4 may be reduced if the insulation sensing voltage ISV is higher than an input voltage range of the ADC 211. The value of the resistor R4 may be increased if the insulation sensing voltage ISV is excessively low to be recognized by the ADC 211.

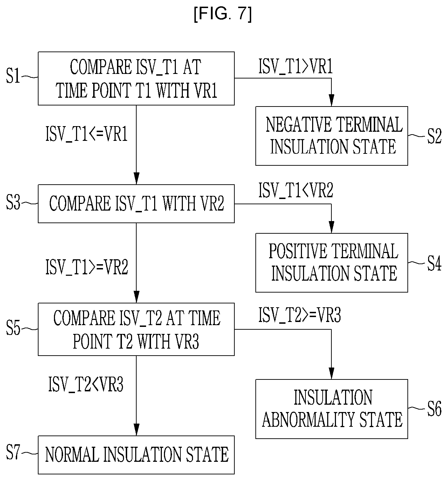

FIG. 7 is a flowchart showing a method for determining the insulation state according to an embodiment.

The method for determining the insulation state that is shown in FIG. 7 may be performed by the insulation diagnosis logic 212.

The insulation diagnosis logic 212 may compare an insulation sensing voltage ISV_T1 at the time point T1 with a first reference voltage VR1 (for example, 2.5 V) (S1). The insulation diagnosis logic 212 may determine the insulation state of the battery pack 10 as the negative terminal insulation state (S2) if the insulation sensing voltage ISV_T1 is more than the first reference voltage VR1 as a result of the comparison in step S1.

The insulation diagnosis logic 212 may compare the insulation sensing voltage ISV_T1 at the time point T1 with a second reference voltage VR2 (for example, 0.5 V) (S3) if the insulation sensing voltage ISV_T1 is the first reference voltage VR1 or less as the result of the comparison in step S1.

The insulation diagnosis logic 212 may determine the insulation state of the battery pack 10 as the positive terminal insulation state (S4) if the insulation sensing voltage ISV_T1 is lower than the second reference voltage VR2 as a result of the comparison in step S3.

The insulation diagnosis logic 212 may compare an insulation sensing voltage ISV_T2 at the time point T2 with a third reference voltage VR3 (for example, 1.5 V) (S5) if the insulation sensing voltage ISV_T1 at the time point T1 is the first reference voltage or less and the second reference voltage or more.

The insulation diagnosis logic 212 may determine the insulation state of the battery pack 10 as the insulation abnormality state (S6) if the insulation sensing voltage ISV_T2 at the time point T2 is the third reference voltage VR3 or more as a result of the comparison in step S5.

The insulation diagnosis logic 212 may determine the insulation state of the battery pack 10 as the normal insulation state (S7) if the insulation sensing voltage ISV_T2 at the time point T2 is less than the third reference voltage VR3 as the result of the comparison in step S5.

Steps S1 through S7 are examples for explaining the method for determining the insulation state based on the insulation sensing voltages ISV_T1 and ISV_T2 at the time points T1 and T2, and the first to third reference voltages VR1 to VR3 are examples for the references for distinguishing the insulation state. However, the present disclosure is not limited thereto.

The present disclosure may be implemented in a manner different from an embodiment described with reference to FIGS. 4 to 7. Hereinafter, a description of another embodiment may omit any description that overlaps the description of an embodiment.

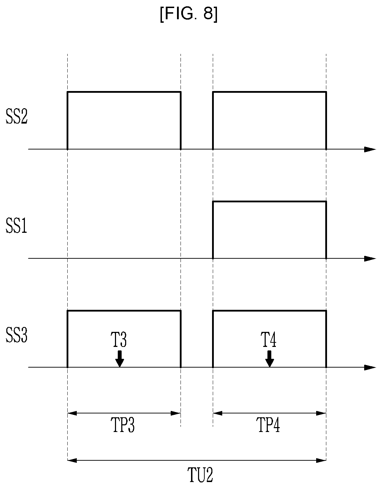

FIG. 8 is a waveform diagram showing signals controlling switching of the plurality of switches according to another embodiment.

A period TU2 in FIG. 8 may be a unit period for the insulation diagnosis. The period TU2 shown in FIG. 8 may be repeated, and the insulation diagnosis may be repeated. When the period TU2 is repeated, a predetermined time interval may exist between two adjacent periods TU2. The insulation diagnosis logic 212 may calculate the insulation resistance in each of the repeated insulation diagnoses, and determine the insulation state of the battery pack 10 based on the calculated insulation resistance value.

As shown in FIG. 8, the period TU2 may include a period TP3 and a period TP4. In the period TP3, the switching control signal SS2 and the switching control signal SS3 may be at the high level which is the on level, and the switching control signal SS1 may be at the low level which is the off level. Therefore, in the period TP3, the switch SW2 and the switch SW3 may be in the on states, and the switch SW1 may be in the off state. The equivalent circuit of the insulation diagnostic circuit in the period TP3 is the same as that in the preceding embodiment shown in FIG. 5.

The time point T3 in FIG. 8 may indicate any time point in the period TP3. The ADC 211 may convert the insulation sensing voltage ISV at the time point T3 into the digital signal. A description of the insulation sensing voltage ISV at the time point T3 is the same as the insulation sensing voltage ISV at the time point T1, referring to Equations 1 and 2 in the preceding embodiment.

In the period TP4, the switching control signal SS2 or the switching control signal SS3 may be at the high level which is the on level. Therefore, in the period TP4, the switch SW2, the switch SW1, and the switch SW3 may be in the on states.

The time point T4 in FIG. 8 may indicate any time point in the period TP4. The ADC 211 may convert the insulation sensing voltage ISV at the time point T4 into the digital signal. A description of the insulation sensing voltage ISV at the time point T4 is the same as the insulation sensing voltage ISV at the time point T2, referring to Equations 3 and 4 in the preceding embodiment.

A description of a method for determining the insulation state by the insulation diagnosis logic 212 is the same as that previously described with reference to FIG. 7.

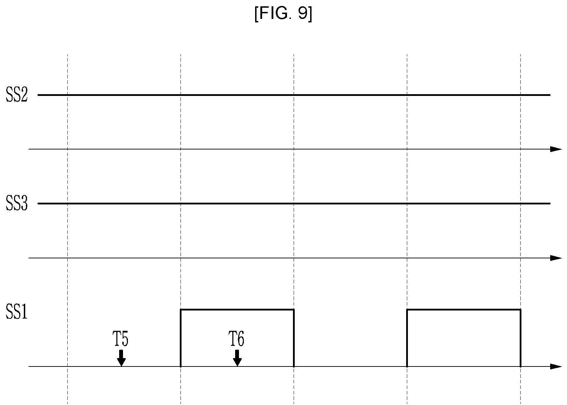

FIG. 9 is a waveform diagram showing signals controlling switching of the plurality of switches according to still another embodiment.

As shown in FIG. 9, in still another embodiment, when the insulation diagnosis is performed, the switch SW2 and the switch SW3 may be controlled to be in the on states, and only the switch SW1 may perform the switching operation at a certain cycle.

At a time point T5, the switching control signal SS2 and the switching control signal SS3 may be at the high level which is the on level, and the switching control signal SS1 may be at the low level which is the off level. The switches SW2 and SW3 may then be in the on states, and the switch SW1 may be in the off state. The ADC 211 may convert the insulation sensing voltage ISV at the time point T5 into the digital signal. A description of the insulation sensing voltage ISV at the time point T5 is the same as the insulation sensing voltage ISV at the time point T1, referring to Equations 1 and 2 in the preceding embodiment.

At a time point T6, the switching control signal SS2 or the switching control signal SS3 may be at the high level which is the on level. Therefore, at the time point T6, the switch SW2, the switch SW1, and the switch SW3 may be in the on states. The ADC 211 may convert the insulation sensing voltage ISV at the time point T6 into the digital signal. A description of the insulation sensing voltage ISV at the time point T6 is the same as the insulation sensing voltage ISV at the time point T2, referring to Equations 3 and 4 in the preceding embodiment.

A description of the method for determining the insulation state by the insulation diagnosis logic 212 is the same as that previously provided with reference to FIG. 7.

The insulation diagnostic circuit according to some embodiments in the present disclosure may include only one switch. In this case, the ADC 211 and/or the insulation diagnosis logic 212 may not be operated when a corresponding period is not the insulation diagnosis period.

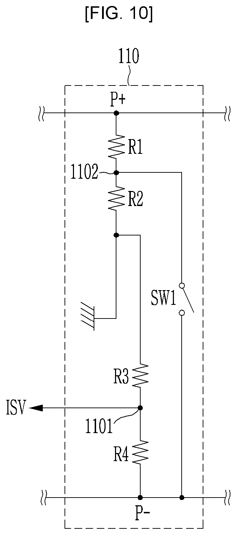

FIG. 10 is a diagram showing an insulation diagnostic circuit according to still another embodiment.

An insulation diagnostic circuit 110 shown in FIG. 10 may include none of the switch SW2 and the switch SW3 compared to the insulation diagnostic circuit 100 previously referring to FIG. 2.

The insulation diagnostic circuit 110 may be connected to the positive terminal P+ and negative terminal P- of the battery pack 10 and the ground. The insulation diagnostic circuit 110 may include the switch SW1 and four resistors R1 to R4.

The resistor R1 and the resistor R2 may be connected between the positive terminal P+ of the battery pack 10 and the ground, and the resistor R3 and the resistor R4 may be connected between the negative terminal P- of the battery pack 10 and the ground. One end of the resistor R1 may be connected to the positive terminal P+ of the battery pack 10, the other end of the resistor R1 and one end of the resistor R2 may be connected to a contact point 1102, and the other end of the resistor R2 may be connected to the ground. One end of the resistor R3 may be connected to the ground, and the other end of the resistor R3 and one end of the resistor R4 may be connected to a contact point 1101. The switch SW1 may be connected between the contact point 1102 and the negative terminal P-. A voltage (or insulation sensing voltage) ISV at the contact point 1101 may be provided to the cell monitoring IC 21.

The ADC 211 may convert the insulation sensing voltage ISV to the digital signal when the switch SW1 is in the off state in the insulation diagnostic circuit 110 shown in FIG. 10. A description of the insulation sensing voltage ISV is the same as the insulation sensing voltage ISV at the time point T1, referring to Equations 1 and 2 in the preceding embodiment. The ADC 211 may convert the insulation sensing voltage ISV to the digital signal when the switch SW1 is in the on state in the insulation diagnostic circuit 110. A description of the insulation sensing voltage ISV is the same as the insulation sensing voltage ISV at the time point T2, referring to Equations 3 and 4 in the preceding embodiment. A description of a method for determining the insulation state by the insulation diagnosis logic 212 is the same as that previously described with reference to FIG. 7.

As described above, in the embodiments, the insulation diagnosis of the battery pack may be performed by the insulation diagnostic circuit having a simplified circuit configuration.

Although the embodiments of the present disclosure have been described in detail hereinabove, the scope of the present disclosure is not limited thereto. That is, various modifications and alterations made by those skilled in the art that use a basic concept of the present disclosure as defined in the following claims also fall within the scope of the present disclosure.

**Claims**

1. An insulation diagnostic circuit for diagnosing an insulation state of a battery pack, the circuit comprising:

   a first resistor and a second resistor connected in series between a positive terminal of the battery pack and a first node;
   a first switch connected between a second node to which the first resistor and the second resistor are connected and a negative terminal of the battery pack;
   a third resistor connected between the first node and a third node; and
   a fourth resistor connected in series between the third node and the negative terminal of the battery pack.

2. The circuit of claim 1, wherein

the first node is connected to a ground.

3. The circuit of claim 1, further comprising:

   a second switch connected between the first node and a ground; and
   a third switch connected between the third node and one end of the fourth resistor.

4. The circuit of claim 3, wherein

   when the second switch and the third switch are in on states and the first switch is in an off state, the first resistor and the second resistor are connected in series between the positive terminal of the battery pack and the ground, the third resistor and the fourth resistor are connected in series between the negative terminal of the battery pack and the ground, a first insulation resistance is formed between the ground and the positive terminal of the battery pack, and a second insulation resistance is formed between the ground and the negative terminal of the battery pack.

5. The circuit of claim 3, wherein

   when the first switch to the third switch are in the on states, the second resistor is connected between the ground and the negative terminal of the battery pack, the third resistor and the fourth resistor are connected between the ground and the negative terminal of the battery pack, a first insulation resistance is formed between the ground and the positive terminal of the battery pack, and a second insulation resistance is formed between the ground and the negative terminal of the battery pack.

6. The circuit of claim 3, wherein
   the second switch is implemented as a photovoltaic metal oxide semiconductor (photoMOS) relay, and the first switch and the third switch are implemented as field-effect transistors (FETs).

7. A battery system comprising:

   a battery pack including a plurality of battery cells;
   an insulation diagnostic circuit for diagnosing an insulation state of the battery pack; and
   a cell monitoring integrated circuit (IC) for diagnosing the insulation state of the battery pack by using an insulation sensing voltage provided from the insulation diagnostic circuit,
   wherein the insulation diagnostic circuit includes

a first resistor and a second resistor connected in series between a positive terminal of the battery pack and a first node,

a first switch connected between a second node to which the first resistor and the second resistor are connected and a negative terminal of the battery pack,

a third resistor connected between the first node and a third node, and

a fourth resistor connected in series between the third node and the negative terminal of the battery pack.

8. The system of claim 7, wherein
the first node is connected to a ground.

9. The system of claim 7, wherein

the cell monitoring IC calculates
a positive terminal insulation resistance between the positive terminal of the battery pack and a ground and a negative terminal insulation resistance between the negative terminal of the battery pack and the ground by using a first insulation sensing voltage, which is a voltage of the third node when the first switch is in an off state, and a second insulation sensing voltage, which is a voltage of the third node when the first switch is in an on state.

10. The system of claim 9, wherein

the first insulation sensing voltage is
a voltage that a ground voltage is resistance-divided by the third resistor and the fourth resistor, the ground voltage is a voltage that a voltage of the battery pack is resistance-divided by a first insulation resistance and a second insulation resistance,

the first insulation resistance is
an equivalent parallel resistance of the third resistor and the fourth resistor connected in series, and the positive terminal insulation resistance, and

the second insulation resistance is
an equivalent parallel resistance of the first resistor and the second resistor connected in series, and the positive terminal insulation resistance.

11. The system of claim 9, wherein

the second insulation sensing voltage is
a voltage that a ground voltage is resistance-divided by the third resistor and the fourth resistor, the ground voltage is a voltage that a voltage of the battery pack is resistance-divided by a first insulation resistance and a second insulation resistance,

the first insulation resistance is
an equivalent parallel resistance of the third resistor and the fourth resistor connected in series, the second resistor, and the negative terminal insulation resistance, and

the second insulation resistance is
the positive terminal insulation resistance.

12. The system of claim 9, wherein

the cell monitoring IC diagnoses
the insulation state of the battery pack by using the first insulation sensing voltage, which is the voltage of the third node when the first switch is in the off state, and the second insulation sensing voltage, which is the voltage of the third node when the first switch is in the on state.

13. The system of claim 12, wherein

the cell monitoring IC determines
that insulation between the positive terminal of the battery pack and the ground, and insulation between the negative terminal of the battery pack and the ground are all in an abnormal state when the first insulation sensing voltage is a predetermined first reference voltage or less and a predetermined second reference voltage or more, and the second insulation sensing voltage is a predetermined third reference voltage or more.

14. The system of claim 12, wherein

the cell monitoring IC determines
that insulation between the positive terminal of the battery pack and the ground, and insulation between the negative terminal of the battery pack and the ground are all in a normal state when the first insulation sensing voltage is a predetermined first reference voltage or less and a predetermined second reference voltage or more, and the second insulation sensing voltage is less than a predetermined third reference voltage.

15. The system of claim 12, wherein

the cell monitoring IC determines
that insulation between the positive terminal of the battery pack and the ground in a normal state, and insulation between the negative terminal of the battery pack and the ground is in an abnormal state when the first insulation sensing voltage is a predetermined first reference voltage or less and less than a predetermined second reference voltage.

**16.** The system of claim 12, wherein

the cell monitoring IC determines that insulation between the negative terminal of the battery pack and the ground in a normal state, and insulation between the positive terminal of the battery pack and the ground is in an abnormal state when the first insulation sensing voltage is more than a predetermined first reference voltage.

**17.** The system of claim 7, wherein

the insulation diagnostic circuit further includes a second switch connected between the first node and a ground, and a third switch connected between the third node and one end of the fourth resistor.

**18.** The system of claim 17, wherein

the cell monitoring IC generates a second switching control signal and a third switching control signal that are on levels for turning on the second switch and the third switch in a first period, and a first switching control signal that is the on level for turning on the first switch in a second period, the first period and the second period overlap each other, and the first period is longer than the second period.

**19.** The system of claim 17, wherein

the cell monitoring IC generates a second switching control signal and a third switching control signal that are on levels for turning on the second switch and the third switch in a first period and a second period, and generates the second switching control signal that is the on level for turning on the first switch in the second period.

[FIG. 1]

[FIG. 2]

[FIG. 3]

[FIG. 4]

[FIG. 5]

[FIG. 6]

[FIG. 7]

S1 — COMPARE ISV_T1 AT TIME POINT T1 WITH VR1

ISV_T1>VR1 → NEGATIVE TERMINAL INSULATION STATE — S2

ISV_T1<=VR1

S3 — COMPARE ISV_T1 WITH VR2

ISV_T1<VR2 → POSITIVE TERMINAL INSULATION STATE — S4

ISV_T1>=VR2

S5 — COMPARE ISV_T2 AT TIME POINT T2 WITH VR3

ISV_T2>=VR3 → INSULATION ABNORMALITY STATE — S6

ISV_T2<VR3

S7 — NORMAL INSULATION STATE

[FIG. 8]

[FIG. 9]

[FIG. 10]

## INTERNATIONAL SEARCH REPORT

| International application No. |
| --- |
| **PCT/KR2024/011565** |

**A. CLASSIFICATION OF SUBJECT MATTER**

**G01R 31/56**(2020.01)i; **G01R 27/02**(2006.01)i; **G01R 1/20**(2006.01)i; **G01R 15/04**(2006.01)i; **G01R 19/165**(2006.01)i

According to International Patent Classification (IPC) or to both national classification and IPC

**B. FIELDS SEARCHED**

Minimum documentation searched (classification system followed by classification symbols)

G01R 31/56(2020.01); G01R 31/36(2006.01); G01R 31/382(2019.01); G01R 31/3835(2019.01); G01R 31/389(2019.01); G01R 31/392(2019.01); G01R 31/396(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 팩(battery pack), 절연 상태(insulation state), 절연 진단 회로(insulation diagnostic circuit), 저항(resistance), 스위치(switch)

**C. DOCUMENTS CONSIDERED TO BE RELEVANT**

| Category* | Citation of document, with indication, where appropriate, of the relevant passages | Relevant to claim No. |
| --- | --- | --- |
| X | KR 10-2023-0069593 A (LG ENERGY SOLUTION, LTD.) 19 May 2023 (2023-05-19) See paragraphs [0005]-[0048], claim 1 and figure 2. | 1-2 |
| Y | | 7-8 |
| A | | 3-6,9-19 |
| Y | KR 10-2022-0043647 A (LG ENERGY SOLUTION, LTD.) 05 April 2022 (2022-04-05) See paragraphs [0006]-[0007] and claim 1. | 7-8 |
| A | KR 10-2099414 B1 (HYUNDAI AUTRON CO., LTD.) 09 April 2020 (2020-04-09) See paragraph [0068], claim 1 and figures 2-6. | 1-19 |
| A | KR 10-2023-0106346 A (LG ENERGY SOLUTION, LTD.) 13 July 2023 (2023-07-13) See paragraphs [0036]-[0045] and figure 1. | 1-19 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **08 November 2024** | **08 November 2024** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
|---|
| **PCT/KR2024/011565** |

**C. DOCUMENTS CONSIDERED TO BE RELEVANT**

| Category* | Citation of document, with indication, where appropriate, of the relevant passages | Relevant to claim No. |
|---|---|---|
| A | KR 10-2021-0060210 A (LG ENERGY SOLUTION, LTD.) 26 May 2021 (2021-05-26)<br>See paragraphs [0061]-[0062] and figures 5 and 9. | 1-19 |

Form PCT/ISA/210 (second sheet) (July 2022)

## INTERNATIONAL SEARCH REPORT
### Information on patent family members

International application No.

**PCT/KR2024/011565**

| Patent document cited in search report | | | Publication date (day/month/year) | Patent family member(s) | | | Publication date (day/month/year) |
|---|---|---|---|---|---|---|---|
| KR | 10-2023-0069593 | A | 19 May 2023 | CN | 116583751 | A | 11 August 2023 |
| | | | | EP | 4239350 | A1 | 06 September 2023 |
| | | | | EP | 4239350 | A4 | 05 June 2024 |
| | | | | JP | 2023-553024 | A | 20 December 2023 |
| | | | | US | 2024-0319284 | A1 | 26 September 2024 |
| | | | | WO | 2023-085777 | A1 | 19 May 2023 |
| KR | 10-2022-0043647 | A | 05 April 2022 | None | | | |
| KR | 10-2099414 | B1 | 09 April 2020 | None | | | |
| KR | 10-2023-0106346 | A | 13 July 2023 | CN | 118251601 | A | 25 June 2024 |
| | | | | EP | 4403944 | A1 | 24 July 2024 |
| | | | | WO | 2023-132670 | A1 | 13 July 2023 |
| KR | 10-2021-0060210 | A | 26 May 2021 | CN | 113557435 | A | 26 October 2021 |
| | | | | CN | 113557435 | B | 05 April 2024 |
| | | | | EP | 3933415 | A1 | 05 January 2022 |
| | | | | EP | 3933415 | A4 | 01 June 2022 |
| | | | | EP | 3933415 | B1 | 14 August 2024 |
| | | | | JP | 2022-531527 | A | 07 July 2022 |
| | | | | JP | 7264578 | B2 | 25 April 2023 |
| | | | | US | 11841389 | B2 | 12 December 2023 |
| | | | | US | 2022-0146561 | A1 | 12 May 2022 |
| | | | | WO | 2021-101059 | A1 | 27 May 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230117682